# EUROPÄISCHE PATENTSCHRIFT

(11) **EP 1 252 497 B1**
(45) Veröffentlichungstag und Bekanntmachung des Hinweises auf die Patenterteilung: **09.01.2008**
(21) Anmeldenummer: 98962395.4
(22) Anmeldetag: 25.11.1998
(51) Int. Cl.: G01N 13/00, G01N 21/75

(54) **VERFAHREN ZUR UNTERSUCHUNG ODER ZUM STRUKTURIEREN EINER OBERFLÄCHENSCHICHT**
METHOD FOR INVESTIGATING OR STRUCTURING A SURFACE LAYER
PROCEDE POUR EXAMINER OU STRUCTURER UNE COUCHE SUPERFICIELLE

(30) Priorität: 04.12.1997 DE 19753790
(43) Veröffentlichungstag der Anmeldung: 30.10.2002
(60) Teilanmeldung: 07017654.0
(73) Patentinhaber: Micronas GmbH, 79108 Freiburg i. Br. (DE)
(72) Erfinder: WOLF, Bernhard, D-79252 Stegen (DE); GAHLE, Hans-Jürgen, D-79312 Emmendingen (DE); IGEL, Günter, D-79331 Teningen (DE); BAUMANN, Werner, D-77815 Bühl (DE); EHRET, Ralf, D-79291 Merdingen (DE); LEHMANN, Mirko, D-79117 Freiburg (DE)
(74) Vertreter: Patentanwälte Westphal, Mussgnug & Partner
(86) Internationale Anmeldenummer: PCT/EP1998/007597
(87) Internationale Veröffentlichungsnummer: WO 1999/030130

(56) Entgegenhaltungen:
- EP-A- 0 749 010
- EP-A- 0 785 424
- DD-A- 285 534
- US-A- 4 924 091
- US-A- 5 442 443

## Beschreibung

Die Erfindung bezieht sich auf ein Verfahren zur Untersuchung der Oberfläche beziehungsweise der Oberflächenschicht eines Objektes auf wenigstens eine topographische und/oder chemische Eigenschaft.

Ein aus N. Streckfuß, Charakterisierung von Siliziumoberflächen mittels Röntgenfluoreszenzanalyse unter Totalreflexionsbedingungen, Verlag Shaker (1995) bereits bekanntes Verfahren zur Ermittlung der chemischen Zusammensetzung eines Objekts ist das Auger-Verfahren. Bei diesem Verfahren wird die Oberfläche eines zu untersuchenden Objekts mit Elektronenstrahlen beschossen oder mit kurzwelliger, energiereicher Strahlung bestrahlt, welche an der Objekt-Oberfläche Sekundär-Elektronen freisetzen. Die Energie dieser Sekundär-Elektronen wird mittels einer geeigneten Sensorik gemessen. Aus der gemessenen Energie kann dann auf die chemische Zusammensetzung des Objekts rückgeschlossen werden.

Aus US 5,442,443 ist auch bereits bekannt, die Topographie eines Oberflächenbereichs eines Objekts durch Tunnelmikroskopie zu ermitteln. Dabei wird im Ultrahochvakuum eine Meßspitze bis auf wenige Zehntel Nanometer an das Objekt herangebracht, an die eine Spannung gegen die Objekt-Oberfläche angelegt wird. Die Meßspitze wird dann rasterförmig an der Objekt-Oberfläche entlangbewegt, wobei der durch die Meßspitze fließende elektrische Strom, der ein Maß für den Abstand der Meßspitze zu der Objekt-Oberfläche ist, gemessen wird.

Ein Nachteil der vorbekannten Verfahren besteht darin, daß diese einen erheblichen apparativen Aufwand erfordern und ihre Anwendung daher entsprechend teuer ist. Ungünstig ist außerdem, daß für die Untersuchung von topographischen und chemischen Eigenschaften des Objekts unterschiedliche Techniken erforderlich sind, was den Aufwand für die Untersuchung des Objekts zusätzlich erhöht. Außerdem ist die Meßempfindlichkeit der vorbekannten Verfahren häufig nicht ausreichend.

Es besteht deshalb die Aufgabe, ein Verfahren zu schaffen, mit dem eine Oberfläche oder eine Oberflächenschicht eines Objekts auf einfache Weise mit hoher Meßempfindlichkeit auf eine topographische und/oder chemische Eigenschaft untersucht werden kann.

Die Lösung dieser Aufgabe besteht darin, daß die Objekt-Oberfläche zur Untersuchung einer topographischen Eigenschaft mit oberflächenstrukturselektiven und/oder zur Untersuchung einer chemischen Eigenschaft mit chemoselektiven Biokomponenten sowie mit einem Nährmedium und/oder einem osmotischen Schutzmedium für die Biokomponenten derart beaufschlagt wird, daß in dem Nährmedium und/oder dem osmotischen Schutzmedium angeordnete Biokomponenten mit der Objekt-Oberfläche in Berührung stehen oder um weniger als die Detektionsreichweite der Biokomponenten von der Objekt-Oberfläche beabstandet sind, daß die Objekt-Oberfläche mit den in dem Nährmedium und/oder dem osmotischen Schutzmedium angeordneten Biokomponenten anschließend untersucht wird, indem wenigstens ein Untersuchungsmeßwert ermittelt wird, und daß der Untersuchungsmeßwert mit einem Referenzmeßwert verglichen und aus dem Ergebnis des Vergleichs auf eine chemische Eigenschaft des Objektes rückgeschlossen wird.

Die Biokomponenten können beispielsweise membranumschlossene Kompartimente, wie biologische Zellen, isolierte Zellbestandteile, wie Zellmembranen, Mikroorganismen (Pilze, Bakterien), Antikörper, Antigene, Rezeptoren, Organellen, Viren, Vesikel, Micelle oder Biomoleküle sein. Gegebenenfalls können die Biokomponenten speziell zum Erkennen chemischer und/oder topographischer Eigenschaften designed sein.

In vorteilhafter Weise wird also zur Untersuchung einer topographischen oder chemischen Eigenschaft eines Objekts die Fähigkeit von Biokomponenten genutzt, auf unterschiedliche topographische oder chemische Gegebenheiten evolutiv bedingt mit hoher Spezifizierung zu reagieren. Dazu werden Biokomponenten in einem Nährmedium und/oder einem osmotischen Schutzmedium zunächst an oder in die Nähe der Objekt-Oberfläche gebracht. Dabei ist es ausreichend, wenn wenigstens ein Teil der Biokomponenten etwas von der Objekt-Oberfläche beabstandet ist, so daß beispielsweise aus der Oberflächenschicht durch das Nährmedium und/oder das osmotische Schutzmedium zu den Biokomponenten diffundierende Stoffe und/oder durch die Oberflächenstruktur bedingte Potentialfelder im Bereich der Objektoberfläche von den Biokomponenten detektiert werden können. Je nach Topographie und/oder chemischer Zusammensetzung der Oberflächenschicht bilden sich dann die Biokomponenten beispielsweise in Farbe, Form und/oder Größe unterschiedlich aus und/oder ordnen sich an der Oberfläche unterschiedlich an. Durch das Nährmedium können die Biokomponenten über einen längeren Zeitraum hinweg vital erhalten werden, so daß sie genügend Zeit zur Verfügung haben, um sich an die chemischen und/oder topographischen Objekteigenschaften anzupassen. Das Nährmedium kann beispielsweise eine Nährflüssigkeit sein, in der die Biokomponenten schwimmen.

Die Objektoberfläche mit den Biokomponenten wird dann optisch untersucht, indem ein oder mehrere Untersuchungsmeßwerte optisch ermittelt werden. Diese werden dann mit Referenzmeßwerten verglichen, die beispielsweise an einem Objekt mit bekannter Oberflächentopographie und/oder mit bekannten chemischen Eigenschaften gemessen wurden. Aus dem Ergebnis des Vergleichs wird dann auf eine topographische und/oder chemische Eigenschaft des untersuchten Objektes geschlossen, indem beispielsweise bei einem weitgehenden Übereinstimmen von Meß- und Referenzwerten Gemeinsamkeiten zwischen den Eigenschaften des untersuchten Objekts und denen des Referenzobjektes und bei einem deutlichen Abweichen der Meßwerte von den Referenzmeßwerten Unterschiede der Eigenschaften des untersuchten Objekts zu dem Referenzobjekt festgestellt werden.

Das erfindungsgemäße Verfahren ermöglicht es, mit vergleichsweise geringem apparativem Aufwand topographische und/oder chemische Eigenschaften eines Objekts zu untersuchen. In vorteilhafter Weise kann bei der Untersuchung der topographischen Eigenschaften die gleiche Technik verwendet werden, wie bei der Untersuchung chemischer Objekt-Eigenschaften. Das Verfahren ist deshalb besonders kostengünstig durchführbar. Außerdem weist das Verfahren eine hohe Meßempfindlichkeit auf, wobei geringste Veränderungen oder Unterschiede in der Oberflächen-Topographie oder in den chemischen Eigenschaften sofort realtime und online erkennbar sind.

Als Biokomponenten können beispielsweise einfach zu handhabende oberflächenstrukturselektive Zellen vom Zelltyp LS 174 T oder stark oberflächenselektive Tumor-Zellen zum Einsatz kommen.

Eine bevorzugte Ausführungsform der Erfindung sieht vor, daß wenigstens ein Teil der Biokomponenten an der Objekt-Oberfläche angelagert wird. Die Biokomponenten stehen dann ständig mit der Oberflächenschicht des Objekts in Berührung, so daß sie auf darin enthaltene chemische Komponenten und/oder auf die Oberflächenstruktur des Objekts besonders empfindlich reagieren können.

Vorteilhaft ist, wenn nach dem Beaufschlagen der Objekt-Oberfläche mit dem Nährmedium und/oder dem osmotischen Schutzmedium und den Biokomponenten in wenigstens zwei zeitlich zueinander beabstanden Zeitpunkten Untersuchungsmeßwerte ermittelt werden. Dabei ist es sogar möglich, daß die in den einzelnen Zeitpunkten ermittelten Meßwerte mit unterschiedlichen Referenzmeßwerten verglichen werden, um zeitabhängigen Veränderungen der Biokomponenten Rechnung zu tragen. Die Meßempfindlichkeit des Verfahrens wird dadurch zusätzlich erhöht.

Zweckmäßigerweise wird wenigstens ein Untersuchungsmeßwert optisch ermittelt. Das Untersuchungsverfahren ist dann besonders einfach durchführbar.

Eine bevorzugte Ausführungsform der Erfindung sieht vor, daß von der Oberfläche mit den Biokomponenten ein optisches Bild aufgenommen wird und daß das Bild durch optische Bildanalyse mit einem Referenzbild verglichen wird. Dadurch ist es beispielsweise möglich, auf einfache Weise mit Methoden der Bildverarbeitung die Verteilung der auf oder in der Nähe Oberfläche befindlichen Biokomponenten zu ermitteln, um daraus Rückschlüsse auf die Struktureigenschaften oder die stofflichen Eigenschaften des Objektes zu ziehen. So ist beispielsweise bei Halbleitern das Anwachsverhalten von biologischen Zellen auf unterschiedlich prozessierten ISFET's mit gleicher Oberfläche unterschiedlich. Somit können durch Auswertung der Oberflächenverteilung der an der Oberfläche eines Halbleiters angelagerten Zellen Informationen über den Fertigungsprozeß des Halbleiters gewonnen werden.

Durch Auswertung der Oberflächenverteilung der an dem Objekt angelagerten Biokomponenten können aber auch chemische Eigenschaften eines Objekts ermittelt werden. So hat sich beispielsweise herausgestellt, daß Zellen vom Zelltyp LS 174 T auf ISFET's, die Kupferbestandteile aufweisen, nicht anwachsen.

Vorteilhaft ist, wenn während des Aufzeichnens des optischen Bildes an der Oberfläche und an diese beaufschlagenden Biokomponenten ein optisches Interferenzmuster erzeugt wird, und wenn das Bild durch optische Bildanalyse mit einem Interferenz-Referenzbild verglichen wird. Dadurch können die Abmessungen und die Anordnung der einzelnen auf oder in der Nähe der Objekt-Oberfläche befindlichen Biokomponenten besonders exakt ermittelt werden.

Vorteilhaft ist, wenn wenigstens ein Untersuchungsmeßwert mittels eines elektrischen, elektronischen oder elektrochemischen Sensors ermittelt wird. So können beispielsweise Stoffwechselprodukte der Biokomponenten, Gasgehalte und/oder Botenstoffe durch elektrochemische Ionenkonzentrationsmessungen ermittelt werden. So kann beispielsweise der Haftungsgrad von biologischen Zellen an der Objektoberfläche sensorisch über den Stoffwechsel festgestellt werden. Ferner können durch Potentialmessungen Informationen über die Biokomponenten gewonnen werden. Da die Lebensbedingungen der Biokomponenten und damit deren Stoffwechsel durch die chemischen und/oder topographischen Eigenschaften der Oberflächenschicht des Objekts beeinflußt wird, ermöglichen die mittels der elektrischen, elektronischen oder elektrochemischen Sensoren gewonnenen Meßsignale Rückschlüsse auf die Eigenschaften der Oberflächenschicht.

Eine vorteilhafte Ausführungsform der Erfindung sieht vor, daß zumindest ein Teil der Biokomponenten auf wenigstens einen in dem zu untersuchenden Objekt enthaltenen wachstums-, struktur- oder funktionsmodulierenden Stoff ansprechende strukturselektive und/oder chemoselektive Biokomponenten sind. Das Verfahren weist dann eine noch größere Meßempfindlichkeit auf. So können beispielsweise Lackreste auf einem Halbleiter dadurch detektiert werden, daß wegen der darin enthaltenen, für die die Biokomponente toxischen Inhaltsstoffe diese dort nicht anwächst.

Vorteilhaft ist, wenn das Nährmedium und/oder das osmotische Schutzmedium mit den darin befindlichen Biokomponenten nach dem Untersuchen der Oberfläche des Objekts von dieser entfernt wird. Nach der Durchführung des Verfahrens verbleiben dann auf der Objekt-Oberfläche keine Rückstände.

Besonders vorteilhaft ist, wenn die Oberfläche eines aus nicht biologischem Material bestehenden und/oder eine Oberflächemchicht aus einem solchen Material aufweisenden Objekts mit den Biokomponenten sowie dem Nähr- und/oder osmotischen Schutzmedium beaufschlagt wird. So können beispielsweise Reste dünner Lackschichten, wie beispielsweise Reste von Abdecklacken für die Fotostrukturierung an der Oberfläche eines Wafers oder dergleichen Halbleiters oder Festkörpers lokalisiert werden. Auf diese Weise lassen sich Erkenntnisse über den Herstellungsprozeß des Wafers gewinnen, mit denen der Herstellungsprozeß optimiert werden kann.

## Patentansprüche

1. Verfahren zur Untersuchung der Oberfläche beziehungsweise der Oberflächenschicht eines Objektes auf wenigstens eine chemische und/oder topographische Eigenschaft, **dadurch gekennzeichnet, daß** die Objekt-Oberfläche zur Untersuchung einer topographischen Eigenschaft mit oberflächenstrukturselektiven und/oder zur Untersuchung einer chemischen Eigenschaft mit chemoselektiven Biokomponenten sowie mit einem Nährmedium und/oder einem osmotischen Schutzmedium für die Biokomponenten derart beaufschlagt wird, daß in dem Nährmedium und/oder dem osmotischen Schutzmedium angeordnete Biokomponenten mit der Objekt-Oberfläche in Berührung stehen oder um weniger als die Detektionsreichweite der Biokomponenten von der Objekt-Oberfläche beabstandet sind, daß die Objekt-Oberfläche mit den in dem Nährmedium und/oder dem osmotischen Schutzmedium angeordneten Biokomponenten anschließend untersucht wird, indem wenigstens ein Untersuchungsmeßwert ermittelt wird, und daß der Untersuchungsmeßwert mit einem Referenzmeßwert verglichen und aus dem Ergebnis des Vergleichs auf eine chemische und/oder topographische Eigenschaft des Objektes rückgeschlossen wird.

2. Verfahren nach Anspruch 1, **dadurch gekennzeichnet, daß** wenigstens ein Teil der Biokomponenten an der Objekt-Oberfläche angelagert wird.

3. Verfahren nach einem der Ansprüche 1 oder 2, **dadurch gekennzeichnet, daß** nach dem Beaufschlagen der Objekt-Oberfläche mit dem Nährmedium und/oder dem osmotischen Schutzmedium und den Biokomponenten in wenigstens zwei zeitlich zueinander beabstanden Zeitpunkten Untersuchungsmeßwerte ermittelt werden.

4. Verfahren nach einem der Ansprüche 1 bis 3, **dadurch gekennzeichnet, daß** wenigstens ein Untersuchungsmeßwert optisch ermittelt wird.

5. Verfahren nach einem der Ansprüche 1 bis 4, **dadurch gekennzeichnet, daß** von der Oberfläche mit den Biokomponenten ein optisches Bild aufgenommen wird und daß das Bild durch optische Bildanalyse mit einem Referenzbild verglichen wird.

6. Verfahren nach einem der Ansprüche 1 bis 5, **dadurch gekennzeichnet, daß** während des Aufzeichnens des optischen Bildes an der Oberfläche und an diese beaufschlagenden Biokomponenten ein optisches Interferenzmuster erzeugt wird, und daß das Bild durch optische Bildanalyse mit einem Interferenz-Referenzbild verglichen wird.

7. Verfahren nach einem der Ansprüche 1 bis 6, **dadurch gekennzeichnet, daß** wenigstens ein Untersuchungsmeßwert mittels eines elektrischen oder elektronischen Sensors ermittelt wird.

8. Verfahren nach einem der Ansprüche 1 bis 7, **dadurch gekennzeichnet, daß** zumindest ein Teil der Biokomponenten auf wenigstens einen in dem zu untersuchenden Objekt enthaltenen wachstums-, struktur- oder funktionsmodulierenden Stoff ansprechende strukturselektive und/oder chemoselektive Biokomponenten sind.

9. Verfahren nach einem der Ansprüche 1 bis 8, **dadurch gekennzeichnet, daß** das Nährmedium und/oder das osmotische Schutzmedium mit den darin befindlichen Biokomponenten nach dem Untersuchen der Oberfläche des Objekts von dieser entfernt werden.

10. Verfahren nach einem der Ansprüche 1 bis 9, **dadurch gekennzeichnet, daß** die Oberfläche eines aus nicht biologischem Material bestehenden und/oder eine Oberflächenschicht aus einem solchen Material aufweisenden Objekts mit den Biokomponenten sowie dem Nähr- und/oder osmotischen Schutzmedium beaufschlagt wird.

11. Verfahren nach einem der Ansprüche 1 bis 10, **dadurch gekennzeichnet, daß** die Oberfläche eines Festkörpers mit den Biokomponenten sowie dem Nähr- und/oder osmotischen Schutzmedium beaufschlagt wird.

## Claims

1. A method for the examination of a surface or the surface layer of an object for at least one chemical and/or topographical property,
**characterised in that** for the examination of a topographical property the surface of the object is charged with surface-structure-selective biocomponents and/or for the examination of a chemical property the surface of the object is charged with chemoselective biocomponents and also with a nutrient medium and/or an osmotic protective medium for the biocomponents in such a manner that biocomponents contained in the nutrient medium and/or the osmotic protective medium are in contact with the surface of the object or are spaced from the surface of the object by less than the detection range of the biocomponents,
**in that** the surface of the object is subsequently examined with the biocomponents contained in the nutrient medium and/or the osmotic protective medium by at least one measured value of the examination being established,
**and in that** the measured value of the examination is compared to a reference measured value and from the result of the comparison conclusions are drawn about a chemical and/or topographical property of the object.

2. A method according to Claim 1,
**characterised in that** at least a portion of the biocomponents is deposited on the surface of the object.

3. A method according to one of Claims 1 or 2,
**characterised in that** after the surface of the object has been charged with the nutrient medium and/or the osmotic protective medium and the biocomponents, measured values of the examination are determined at at least two instants set apart in time.

4. A method according to one of Claims 1 to 3,
**characterised in that** at least one measured value of the examination is optically determined.

5. A method according to one of Claims 1 to 4,
**characterised in that** an optical image of the surface of the object with the biocomponents is recorded
**and in that** the image is compared to a reference image using optical image analysis.

6. A method according to one of Claims 1 to 5,
**characterised in that** an optical interference pattern is created during the recording of the optical image at the surface and at biocomponents charging it,
**and in that** the image is compared to a reference interference image using optical image analysis.

7. A method according to one of Claims 1 to 6,
**characterised in that** at least one measured value of the examination is determined using an electric or electronic sensor.

8. A method according to one of Claims 1 to 7,
**characterised in that** at least a portion of the biocomponents are structure-selective and/or chemoselective biocomponents responsive to at least one growth-modulating, structure-modulating or function-modulating substance contained in the object to be examined.

9. A method according to one of Claims 1 to 8,
**characterised in that** the nutrient medium and/or the osmotic protective medium with the biocomponents contained therein is/are removed from the surface of the object after said surface has been examined.

10. A method according to one of Claims 1 to 9,
**characterised in that** the surface of an object made from non-biological material and/or comprising a surface layer made from such a material is charged with the biocomponents and the nutrient medium and/or osmotic protective medium.

11. A method according to one of Claims 1 to 10,
**characterised in that** the surface of a solid body is charged with the biocomponents and the nutrient medium and/or osmotic protective medium.

## Revendications

1. Procédé permettant d'examiner une surface ou une couche superficielle d'un objet au sujet d'au moins une propriété topographique et/ou chimique,
**caractérisé en ce qu'**
on soumet la surface d'un objet pour en étudier une propriété topographique, à des biocomposants sélectifs pour les structures superficielles et/ou chimiosélectifs pour étudier une propriété chimique ainsi qu'à un milieu nutritif et/ou à un milieu protecteur osmotique pour les biocomposants de manière à ce que les biocomposants disposés dans le milieu nutritif et/ou le milieu protecteur osmotique soient en contact avec la surface de l'objet ou soient à une distance inférieure à la portée de détection des biocomposants de la surface de l'objet,
la surface de l'objet est ensuite étudiée avec les biocomposants disposés dans le milieu nutritif et/ou le milieu protecteur osmotique en déterminant au moins une valeur d'étude, et
la valeur d'étude est comparée à une valeur mesurée de référence et une propriété chimique et/ou topographique de l'objet est déduite du résultat de la comparaison.

2. Procédé selon la revendication 1,
**caractérisé en ce qu'**
des biocomposants sont fixés au moins en partie à la surface de l'objet.

3. Procédé selon l'une des revendications 1 ou 2,
**caractérisé en ce qu'**
on détermine des valeurs d'étude à au moins deux moments distants l'un de l'autre dans le temps après avoir soumis la surface de l'objet au milieu nutritif et/ou au milieu protecteur osmotique et aux biocomposants.

4. Procédé selon l'une des revendications 1 à 3,
**caractérisé en ce qu'**
on détermine visuellement au moins une valeur d'étude.

5. Procédé selon l'une des revendications 1 à 4,
**caractérisé en ce qu'**
on prend une image optique de la surface comportant les biocomposants et on compare l'image par analyse optique de l'image à une image de référence.

6. Procédé selon l'une des revendications 1 à 5,
**caractérisé en ce que**
on produit un modèle d'interférence optique pendant l'enregistrement de l'image optique à la surface et des biocomposants auxquels elle est soumise, et on compare l'image, par analyse optique de l'image, à une image d'interférence de référence.

7. Procédé selon l'une des revendications 1 à 6,
**caractérisé en ce qu'**
on détermine au moins une valeur d'étude au moyen d'un capteur électrique ou électronique.

8. Procédé selon l'une des revendications 1 à 7,
**caractérisé en ce qu'**
au moins une partie des biocomposants sont des biocomposants structurellement sélectifs et/ou chimiosélectifs répondant à au moins une substance modulant la croissance, la structure ou la fonction contenue dans l'objet à étudier.

9. Procédé selon l'une des revendications 1 à 8,
**caractérisé en ce qu'**
on retire le milieu nutritif et/ou le milieu protecteur osmotique avec les biocomposants se trouvant à l'intérieur de la surface de l'objet après avoir examinée celle-ci.

10. Procédé selon l'une des revendications 1 à 9,
**caractérisé en ce que**
la surface d'un objet non constitué d'une matière biologique et/ou présentant une couche superficielle d'une telle matière est soumise aux biocomposants ainsi qu'au milieu nutritif et/ou protecteur osmotique.

11. Procédé selon l'une des revendications 1 à 10,
**caractérisé en ce qu'**
on soumet la surface d'un corps solide est soumise aux biocomposants ainsi qu'au milieu nutritif et/ou protecteur osmotique.
